# EUROPEAN PATENT SPECIFICATION

(11) **EP 2 679 893 B1**
(45) Date of publication and mention of the grant of the patent: **28.03.2018**
(21) Application number: 12749517.4
(22) Date of filing: 09.02.2012
(51) Int. Cl.: F21V 19/00, F21V 3/00, F21V 3/02, F21V 17/00, H01L 51/50, H05B 33/06, F21Y 105/00

(54) **ILLUMINATION DEVICE**
BELEUCHTUNGSVORRICHTUNG
DISPOSITIF D'ÉCLAIRAGE

(30) Priority: 22.02.2011 JP 2011035710
(43) Date of publication of application: 01.01.2014
(73) Proprietor: Konica Minolta, Inc., Tokyo 100-7015 (JP)
(72) Inventor: WAKAHARA, Junya, Chiyoda-ku Tokyo 100-7015 (JP); MIKI, Nobuya, Chiyoda-ku Tokyo 100-7015 (JP); YONEYAMA, Masatoshi, Chiyoda-ku Tokyo 100-7015 (JP); MASAZUMI,Naoki, Chiyoda-ku Tokyo 100-7015 (JP); HONDA,Yasuhiro, Chiyoda-ku Tokyo 100-7015 (JP)
(74) Representative: Hoffmann Eitle
(86) International application number: PCT/JP2012/052949
(87) International publication number: WO 2012/114887

(56) References cited:
- EP-A1- 1 182 493
- EP-A1- 2 042 897
- EP-A1- 2 058 584
- WO-A1-2008/069582
- WO-A1-2010/064501
- FR-A1- 2 937 929
- JP-A- 2002 072 915
- JP-A- 2002 072 915
- JP-A- 2002 117 808
- JP-A- 2002 542 514
- JP-A- 2005 166 426
- JP-A- 2007 005 226
- JP-A- 2009 076 388
- JP-A- 2009 076 388
- JP-A- 2009 245 611
- JP-A- 2009 289 482
- JP-A- 2009 289 482
- JP-A- 2010 145 731
- US-A1- 2009 303 744
- US-A1- 2010 046 232
- US-B1- 6 170 958
- US-B1- 6 357 893
- US-B1- 7 182 627

## Description

### TECHNICAL FIELD

The present invention relates to an illumination device, and in particular relates to an illumination device provided with a sheet-shaped illumination panel.

### BACKGROUND ART

In recent years, in place of a point light emitting illumination device such as an incandescent bulb or a LED (Light Emitting Diode), a surface light emitting illumination device having an illumination panel is drawing attention. Japanese Patent Laid-Open No. 2004-055535 (PTD 1) discloses an illumination device which is provided with an organic EL (OLED: Organic Light Emitting Diode) as the illumination panel.

In the illumination device of Japanese Patent Laid-Open No. 2004-055535 (PTD 1), the illumination panel (OLED) is formed into a sheet shape. The sheet-shaped illumination panel is installed on an obverse face of a main body (supporting body). The sheet-shaped illumination panel shapes in accordance with the superficial shape of the main body and thereafter is installed on the obverse face of the main body through the use of an adhesive agent, a clip or the like.

US-B-6,170,958 discloses a night light including an electro-luminescent element connected to an electrical plug by conductive elements compressed between electrodes of the electro-luminescent element and prongs of the electrical plug. The electro-luminescent element is captured between an inner plate and a front part of the housing so as to cause the electro-luminescent element to conform to a curved surface of the housing without the need for additional plastic housing material, the inner plate also serving to apply a biasing force against the conductive elements.

US-B-6,357,893 discloses a device that uses a plurality of light sources. The light sources are arranged and mounted to a deformable flexible substrate so as to emit their radiation perpendicular to the substrate. The substrate is flexed in a concave or convex manner by motor, magnetic field or other mechanical means.

EP-A-2 042 897 discloses a planar lighting device comprising, in addition to light sources, a light guide plate including a light exit plane, a pair of first light entrance planes respectively formed on a pair of sides of the light exit plane, a pair of lateral planes respectively formed on the other pair of sides of the light exit plane and a rear plane composed of a pair of inclined planes formed on a side opposite from the light exit plane. The light sources emit light to the pair of light entrance planes of the light guide plate. Such a device is also disclosed in US-A-2009/0303744.

US-A-2010/0046232 discloses a lighting device including a heat sink, a socket and an LED module. The LED module has a light emitting unit in a central part of a top side of a metal base substrate composed of an insulating plate and a metal plate. The LED module is warped such that the central part protrudes on a heat sink side, which is the side opposite to the light emitting unit side. The LED module is mounted on the heat sink in a state of the surroundings of the light emitting unit being pressed by pressing units of the socket.

### CITATION LIST

### PATENT DOCUMENT

PTD 1: Japanese Patent Laid-Open No. 2004-055535

### SUMMARY OF INVENTION

### TECHNICAL PROBLEM

In the illumination device of Japanese Patent Laid-Open No. 2004-055535 (PTD 1), light distribution characteristics of the illumination panel are not taken into consideration. Thereby, for the illumination device of PTD 1, the intensity of light from the illumination panel may be irregular depending on the direction of illumination.

An object of the present invention is to provide an illumination device including a sheet-shaped illumination panel and capable of achieving desired light distribution characteristics of the illumination panel.

### SOLUTION TO PROBLEM

The illumination device according to the present invention includes the features of claim 1.

### ADVANTAGEOUS EFFECTS OF INVENTION

According to the present invention, it is possible to obtain the illumination device including a sheet-shaped illumination panel and capable of achieving desired light distribution characteristics of the illumination panel.

### BRIEF DESCRIPTION OF DRAWINGS

Fig. 1 is a perspective view illustrating an illumination device according to Embodiment 1 in an exploded state;
Fig. 2 is a cross sectional view taken along a line II-II in Fig. 1;
Fig. 3 is a cross sectional view taken along a line III-III in Fig. 1;
Fig. 4 is a cross sectional view taken along a line IV-IV in Fig. 1;
Fig. 5 is a top view of an illumination panel used in the illumination device according to Embodiment 1;
Fig. 6 is a bottom view of the illumination panel used in the illumination device according to Embodiment 1;
Fig. 7 is a perspective view illustrating the illumination device according to Embodiment 1 in an assembled state;
Fig. 8 is a cross sectional view illustrating a modification of a retaining member used in the illumination device according to Embodiment 1;
Fig. 9 is a cross sectional view illustrating the illumination device according to Embodiment 1 before being installed on a ceiling;
Fig. 10 is a cross sectional view illustrating the illumination device according to Embodiment 1 after being installed on the ceiling;
Fig. 11 is a perspective view illustrating an installation cover used in an illumination device according to a first modification of Embodiment 1;
Fig. 12 is a plan view illustrating an installation cover used in an illumination device according to a second modification of Embodiment 1;
Fig. 13 is a cross sectional view illustrating an illumination device according to a third modification of Embodiment 1;
Fig. 14 is a side view illustrating another configuration of the illumination device (before an installation cover is installed on a main body) according to the third modification of Embodiment 1;
Fig. 15 is a side view illustrating another configuration of the illumination device (after the installation cover is installed on the main body) according to the third modification of Embodiment 1;
Fig. 16 is a side view illustrating still another configuration of the illumination device (after the installation cover is installed on the main body) according to the third modification of Embodiment 1;
Fig. 17 is a side view illustrating still another configuration of the illumination device (before the installation cover is installed on the main body) according to the third modification of Embodiment 1;
Fig. 18 is a bottom view of an illumination panel used in an illumination device according to a fourth modification of Embodiment 1;
Fig. 19 is a bottom view of an illumination panel used in an illumination device according to a fifth modification of Embodiment 1;
Fig. 20 is a bottom view illustrating an installation cover used in an illumination device according to a sixth modification of Embodiment 1;
Fig. 21 is a cross sectional view taken along a line XXI-XXI in Fig. 20;
Fig. 22 is a bottom view illustrating a state where the illumination panel is mounted on a pressing region of the installation cover used in the illumination device according to the sixth modification of Embodiment 1;
Fig. 23 is a cross sectional view taken along a line XXIII-XXIII in Fig. 22;
Fig. 24 is a bottom view illustrating an installation cover used in an illumination device according to a seventh modification of Embodiment 1;
Fig. 25 is a cross sectional view taken along a line XXV-XXV in Fig. 24;
Fig. 26 is a bottom view illustrating a state where the illumination panel is mounted on a pressing region of the installation cover used in the illumination device according to the seventh modification of Embodiment 1;
Fig. 27 is a cross sectional view taken along a line XXVII-XXVII in Fig. 26;
Fig. 28 is a cross sectional view illustrating another configuration of the installation cover (prefixing portion) used in the illumination device according to the seventh modification of Embodiment 1;
Fig. 29 is a bottom view illustrating an installation cover used in an illumination device according to an eighth modification of Embodiment 1;
Fig. 30 is a perspective view illustrating a portion nearby a guide member of an installation cover used in the illumination device according to the eighth modification of Embodiment 1;
Fig. 31 is a bottom view illustrating an illumination panel used in the illumination device according to the eighth modification of Embodiment 1;
Fig. 32 is a bottom view illustrating an installation cover used in an illumination device according to a ninth modification of Embodiment 1;
Fig. 33 is a bottom view illustrating an illumination panel used in the illumination device according to the ninth modification of Embodiment 1;
Fig. 34 is a bottom view illustrating an installation cover used in an illumination device according to a tenth modification of Embodiment 1;
Fig. 35 is a bottom view illustrating an illumination panel used in the illumination device according to the tenth modification of Embodiment 1;
Fig. 36 is a front view illustrating a main body and an installation cover used in an illumination device according to Embodiment 2;
Fig. 37 is a cross sectional view taken along a line XXXVII-XXXVII in Fig. 36;
Fig. 38 is a front view illustrating the illumination device according to Embodiment 2 in an assembled state;
Fig. 39 is a cross sectional view taken along a line XXXIX-XXXIX in Fig. 38;
Fig. 40 is a front view illustrating an illumination device according to a modification of Embodiment 2; and
Fig. 41 is a cross sectional view taken along a line XLI-XLI in Fig. 40.

### DESCRIPTION OF EMBODIMENTS

Each embodiment of the present invention will be described hereinafter with reference to the drawings. In the description of each embodiment, unless otherwise specified, the scope of the present invention is not necessarily limited to the numbers or amounts indicated in each embodiment. In the description of each embodiment, the same or corresponding components are given the same reference numbers and may not be described repeatedly. Unless otherwise specified, an appropriate combination of configurations illustrated respectively in the embodiments has been initially expected.

### [Embodiment 1]

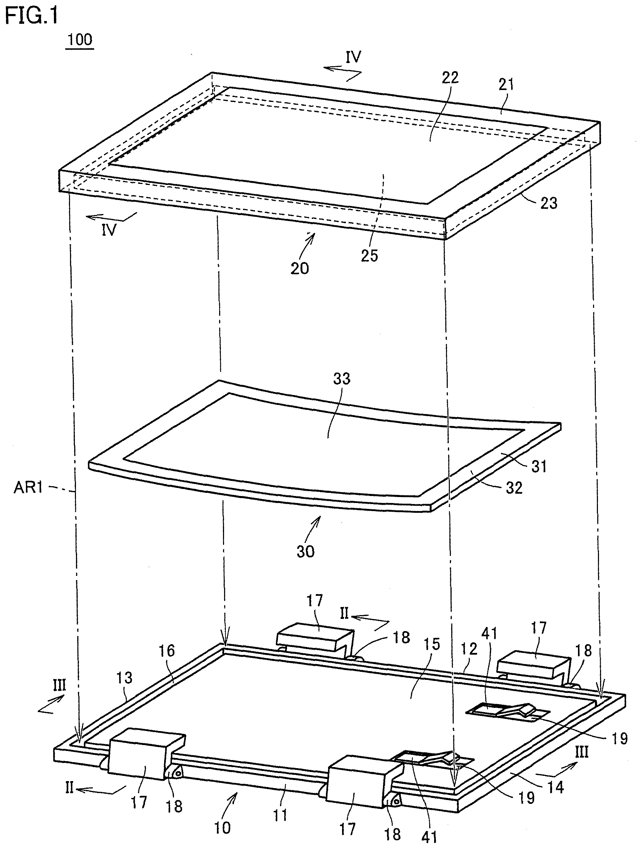

Fig. 1 is a perspective view illustrating an illumination device 100 according to the present embodiment in an exploded state (prior to assembly). Illumination device 100 includes a main body 10, an installation cover 20 and an illumination panel 30. As illustrated by an arrow AR1, installation cover 20 is installed on main body 10, sandwiching both main body 10 and illumination panel 30 (the details will be given later).

### (Main Body 10)

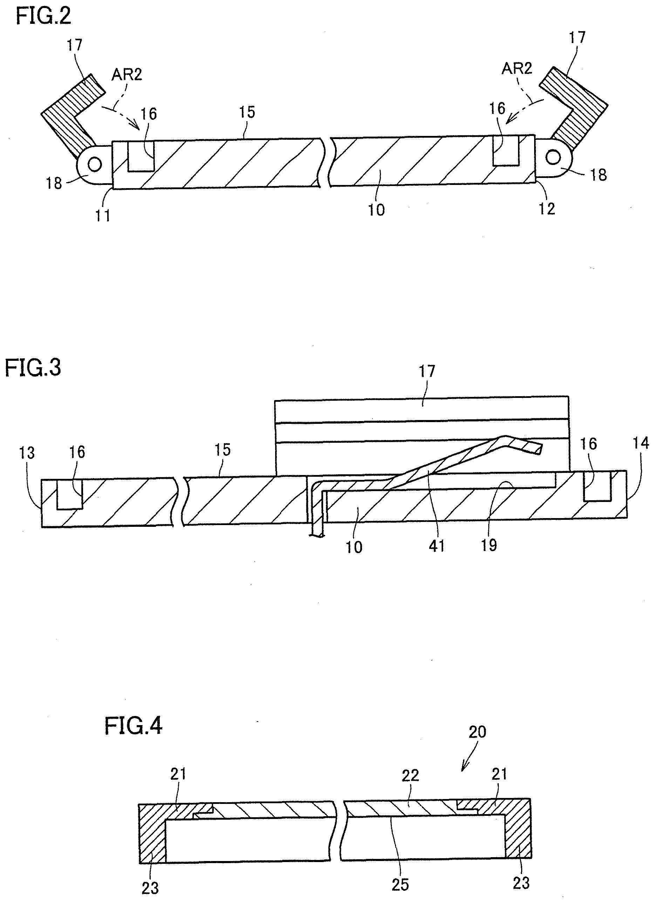

Fig. 2 is a cross sectional view taken along a line II-II in Fig. 1, and Fig. 3 is a cross sectional view taken along a line III-III in Fig. 1. As illustrated in Figs. 1 to 3, main body 10 is formed into a plate shape, and includes ends 11 to 14 and a mounting face 15. Main body 10 can be fixed on a ceiling (not shown), a wall surface (not shown) or the like through the intermediary of a rear face (opposite to mounting face 15). Main body 10 is made of, for example, aluminum or stainless steel through a pressing operation or a cutting operation. The thickness of main body 10 is, for example, from 2 cm to 10 cm.

Main body 10 is disposed with an annular groove 16 (see Figs. 1 to 3) having a predetermined depth along a peripheral edge of mounting face 15. To be described in detail hereinafter, the shape of annular groove 16 fits with the shape of an embedding portion 23 (see Figs. 1 and 4) disposed on installation cover 20. When illumination device 100 is in the assembled state, embedding portion 23 of installation cover 20 is embedded in annular groove 16 of main body 10.

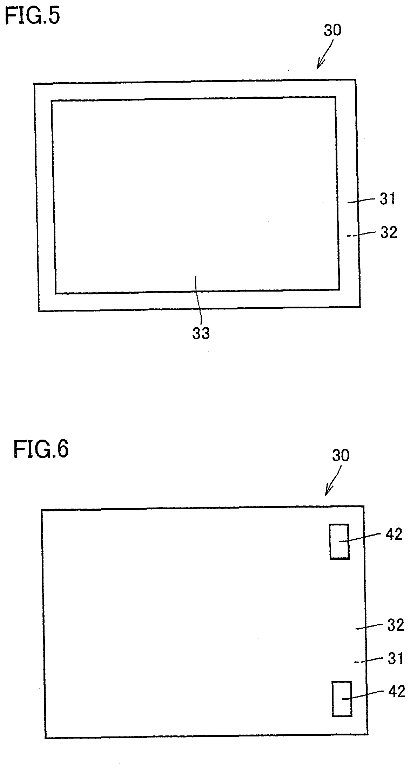

As illustrated in Figs. 1 and 3, two cutouts 19 are carved side by side at predetermined positions on mounting face 15. A pair of electrical contacts 41 (first electrical contact) are disposed inside cutouts 19, respectively. Electrical contacts 41 are positioned in such a way that they can have a contact with electrical contacts 42 (see Fig. 6) of illumination panel 30 when illumination panel 30 is installed on main body 10.

As illustrated in Fig. 3, electrical contacts 41 disposed inside cutouts 19 may be fixed therein with a portion thereof protruding out of mounting face 15 like a plate spring. According to this configuration, when illumination panel 30 is installed on main body 10, a good electrical connection is achieved between electrical contacts 42 (see Fig. 6) of illumination panel 30 and electrical contacts 41 of main body 10. Electrical contacts 41 penetrate through main body 10 (see Fig. 3), and are connected to a predetermined power source (not shown).

As illustrated in Figs. 1 and 2, two supporting units 18 are disposed side by side at end 11 and end 12 facing each other, respectively. An L-shaped retaining member 17 is rotatably installed at supporting unit 18. A biasing unit such as a coil spring or the like is built inside supporting unit 18. Due to the action from the biasing unit such as a coil spring or the like, retaining member 17 installed at supporting unit 18 is biased to rotate toward mounting face 15 in the direction of an arrow AR2 (see Fig. 2).

### (Installation Cover 20)

Fig. 4 is a cross sectional view taken along a line IV-IV in Fig. 1. As illustrated in Figs. 1 and 4, installation cover 20 includes a plate member 21 and embedding portion 23. Embedding portion 23 is erected circularly around the outer periphery of plate member 21. As mentioned in the above, the shape of embedding portion 23 fits with the shape of annular groove 16 (see Fig. 1) disposed on main body 10.

The inner peripheral side of plate member 21 is disposed with a rectangular transparent plate 22 (transparent region) made of glass, acryl resin or the like. The thickness of transparent plate 22 is, for example, from 2 mm to 3 mm. The rear face (where embedding portion 23 is erected) of transparent plate 22 defines a pressing region 25. The surface shape of pressing region 25 (the shape of the rear face of transparent plate 22) fits with the surface shape of mounting face 15. When illumination device 10 is in an assembled state, pressing region 25 presses the entire part of a light emitting face 33 of illumination panel 30 against mounting face 15 of main body 10.

### (Illumination Panel 30)

Fig. 5 is a top view of illumination panel 30, and Fig. 6 is a bottom view of illumination panel 30. Illumination panel 30 is formed into a shape of a flexible sheet (see Figs. 1, 5 and 6). The thickness of illumination panel 30 is, for example, about 1 mm. Here, a sheet represents a planar sheet having a thickness from about 0.5 mm to about 10 mm, preferably having a substantially uniform thickness from about 0.5 mm to about 1 mm, and also includes such a sheet of a thickness as those referred to as a film sheet or a thin-plate sheet.

The rectangular light emitting face 33 which emits light when supplied with electrical power is formed on an obverse face 31 of illumination panel 30. Light emitting face 33 may be constructed from, for example, organic EL (OLED: Organic Light Emitting Diode) elements. A rear face 32 of illumination panel 30 is disposed with a pair of electrical contacts 42 (second electrical contact) for supplying electrical power to light emitting face 33.

In the case where light emitting face 33 is constructed from organic EL elements, electrical power is supplied to both sides of an organic light emitting layer inside light emitting face 33. When supplied with electrical power, the organic light emitting layer emits visible light. A transparent electrode layer (such as ITO) is disposed on the organic light emitting layer at the side of light emitting face 33 (the side of obverse face 31), and the transparent electrode layer is sealed by a sealing layer. An electrode layer, for example an aluminum electrode layer configured to reflect the emitted light, is disposed underneath the organic light emitting layer (at the side of rear face 32). Underneath the electrode layer (the side of rear face 32), a base layer is disposed. The electrode layers on both sides of the organic light emitting layer are wired, according to a predetermined pattern, to the pair of electrical contacts 42 disposed on rear face 32, respectively.

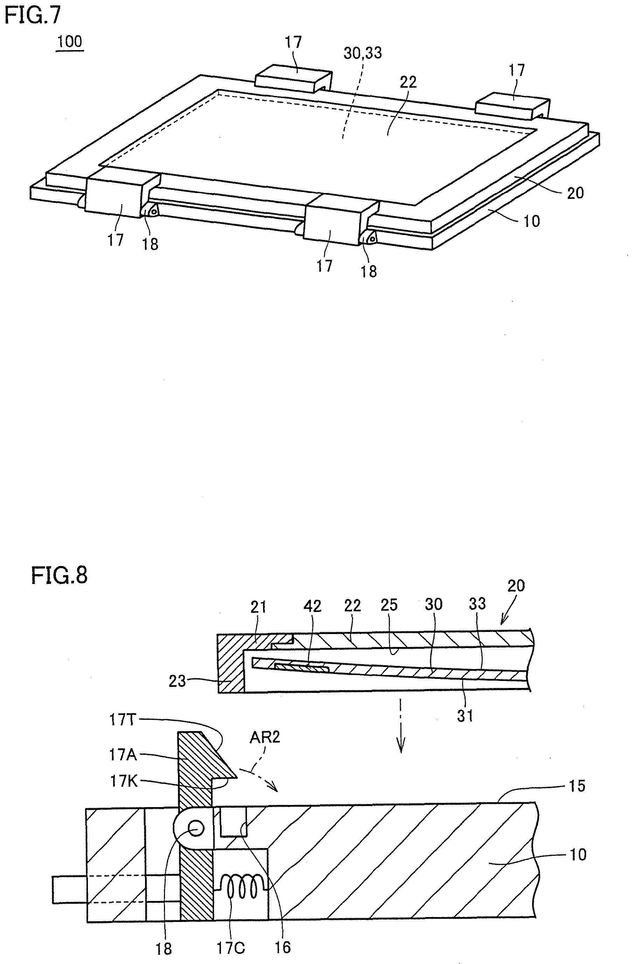

Fig. 7 is a perspective view illustrating illumination device 100 in an assembled state (after being assembled). In assembling illumination device 100, main body 10 and installation cover 20 are arranged opposite to each other, sandwiching illumination panel 30 therebetween (see Figs. 1 and 7). Retaining member 17 of main body 10 is rotated in the direction opposite to arrow AR2 (see Fig. 2) so as to be erected. Retaining member 17 may be kept at an erected state against the biasing force of a coil spring or the like through hooking by using, for example, a latch mechanism (not shown).

Then, embedding portion 23 of installation cover 20 is embedded into annular groove 16 of main body 10. Thus, illumination panel 30 is sandwiched by transparent plate 22 (pressing region 25) of installation cover 20 and mounting face 15 of main body 10. Thereafter, the hooking by the latch mechanism is released according to the operation of a release lever or a release button (not shown). Accordingly, the erected state of retaining member 17, which is kept by the latch mechanism through hooking, is also released. Thereby, retaining member 17 is biased by a coil spring or the like to rotate in the direction of arrow AR2 (see Fig. 2). Retaining member 17 presses plate member 21 of installation cover 20 toward mounting face 15.

Due to the pressing from retaining member 17, installation cover 20 and illumination panel 30 are installed on main body 10. Pressing region 25 (see Figs. 1 and 4) presses light emitting face 33 toward mounting face 15. According the abovementioned procedure, illumination device 100 as illustrated in Fig. 7 is obtained. In illumination device 100, electrical power is supplied to light emitting face 33 of illumination panel 30 from an external power source (not shown) through the intermediary of electrical contacts 41 (see Fig. 1) disposed on main body 10 and electrical contacts 42 (see Fig. 6) disposed on illumination panel 30. When supplied with the electrical power, light emitting face 33 emits light, which makes illumination device 100 ready for illumination.

According to the approach described above with reference to Fig. 2 and the like, in installing illumination panel 30 on main body 10, retaining member 17 is rotated in the direction opposite to arrow AR2. While retaining member 17 is in the erected state according to the hooking by the latch mechanism, illumination panel 30 is installed on main body 10. Thereafter, the hooking by the latch mechanism is released, and illumination panel 30 is fixed on main body 10 by a biasing force in the direction of arrow AR2 by a coil spring or the like. However, the approach of installing illumination panel 30 on main body 10 is not limited to that illustrated in Fig. 2 and the like as mentioned in the above, and it is acceptable to adopt a configuration using a retaining member 17A as illustrated in Fig. 8 to do the same.

According to an approach as illustrated in Fig. 8, in installing illumination panel 30 and installation cover 20 on main body 10, it is unnecessary to manually rotate retaining members 17A one by one in the direction opposite to arrow AR2. Specifically, a tip end 17T of retaining member 17A is made inclined so as to accept embedding portion 23 of installation cover 20. When pressing installation cover 20 and illumination panel 30 toward a predetermined installation position on main body 10, embedding portion 23 of installation cover 20 contacts tip end 17T of retaining member 17A.

At this time, embedding portion 23 of installation cover 20 pushes retaining member 17A toward the direction opposite to arrow AR2. Thereby, retaining member 17A rotates in the direction opposite to arrow AR2 against the biasing force from a coil spring 17C. At a timing when embedding portion 23 of installation cover 20 passes over tip end 17T of retaining member 17A (the timing when embedding portion 23 of installation cover 20 loses the contact with tip end 17T of retaining member 17A), retaining member 17A restores in the direction of arrow AR2 due to the biasing force from coil spring 17C. Illumination panel 30 and installation cover 20 are pressed against main body 10 by an engaging section 17K disposed in retaining member 17A. According to the configuration illustrated in Fig. 8, it is possible to easily install illumination panel 30 and installation cover 20 on main body 10.

### (Functions and Effects)

As shown in Fig. 1, the sheet-shaped illumination panel 30 may bend in the direction of gravity due to initial distortions (such as a warp or the like resulting from manufacture or transportation) and/or due to the weight (dead weight) of illumination panel 30 itself according to an installation manner thereof. According to illumination device 100 of the present embodiment, light emitting face 33 of illumination panel 30 is pressed against mounting face 15 by pressing region 25 of installation cover 20. Thus, light emitting face 33 is being sandwiched by pressing region 25 and mounting face 15, and thereby the shape thereof is retained.

In the illumination device of Japanese Patent Laid-Open No. 2004-055535 (PTD 1), which is described in the beginning, the sheet-shaped illumination panel is installed on the obverse face of the main body (supporting body). One face of the sheet-shaped illumination panel in PTD 1 is in contact with the main body, and the other face thereof is not in contact with any members but exposed as the light emitting face (the so-called "single face-contacting installation structure"). When the illumination device in PTD 1 is installed on a ceiling, a wall surface or the like, the illumination panel may bend due to its dead weight. Since the illumination device in PTD 1 adopts the so-called single face-contacting installation structure, the bending of the illumination panel remains even after the installation.

Even when illumination device 100 of the present embodiment is installed on the ceiling, the wall surface or the like, since light emitting face 33 is being pressed by pressing region 25, it will not bend. Thereby, according to the configuration where the shape of pressing region 25 of installation cover 20 and the shape of mounting face 15 of main body 10 are formed fitting with the desired shape of light emitting face 33 and illumination panel 30 is sandwiched by installation cover 20 and mounting face 15, it is possible to keep light emitting face 33 at the initially designed shape. Thereby, it is possible for light emitting face 33 to achieve the initially designed light distribution characteristics without causing the problem that the intensity of light from light emitting face 33 may become irregular (uneven) depending on the direction of illumination from light emitting face 33.

In the illumination device of PTD 1, the retaining members for pre-installing the illumination panel on the main body (supporting body) are designed to have a predetermined distance therebetween. Correspondingly, both ends of the illumination panel each is disposed preliminarily with a clip or the like. However, due to manufacturing error or the like, the distance between the retaining members may not fit with the distance between the clips disposed at both ends of the illumination panel. In forming the illumination panel into the sheet shape, due to the characteristics of the illumination panel, such manufacturing error is easy to occur. In the case where the distance between the retaining members is different from the distance between the clips, such problem may occur that the illumination panel may have to be crinkled in order to be installed on the main body.

In illumination device 100 of the present embodiment, illumination panel 30 is fixed through the way of being sandwiched by main body 10 and installation cover 20. Even in the case where illumination panel 30 is manufactured with dimensions different from the initially designed dimensions along, for example, the longitudinal direction, since illumination panel 30 is being fixed against main body 10 and installation cover 20 according to the pressing from both the obverse face and the rear
face, no crinkles will occur. Even at this viewpoint, it is possible for illumination device 100 to achieve the desired light distribution characteristics.

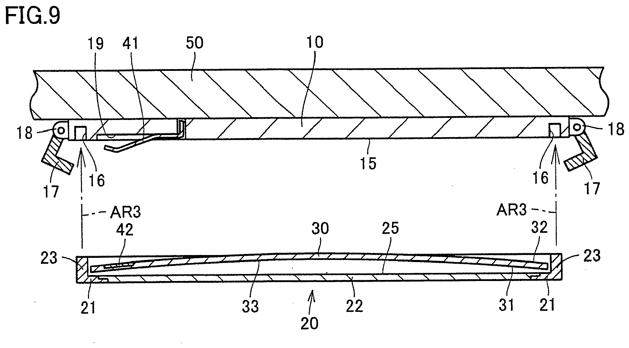

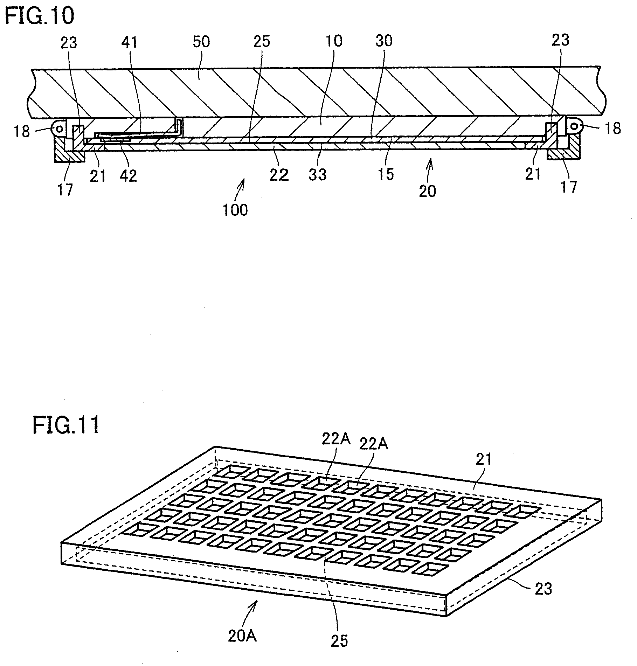

With reference to Figs. 9 and 10, the installation of illumination device 100 (see Fig. 10) on ceiling 50 will be described. In Figs. 9 and 10, retaining member 17 and supporting unit 18 are installed at positions deviated 90° from the positions illustrated in Fig. 1. In other words, the installation positions of retaining member 17 and supporting unit 18 may be at the positions illustrated in Fig. 1 (retaining member 17 and supporting unit 18 are configured to be installed on ends 11 and 12) or may be at the positions illustrated in Figs. 9 and 10 (retaining member 17 and supporting unit 18 are configured to be installed on ends 13 and 14).

In the case of installing illumination device 100 (see Fig. 10) on ceiling 50, firstly, main body 10 is fixed on ceiling 50 through bolts and nuts or the like. Thereafter, illumination panel 30 is mounted on pressing region 25 of installation cover 20, with light emitting face 33 facing downward. Under this condition, as illustrated by an arrow AR3, embedding portion 23 of installation cover 20 is embedded into annular groove 16 of main body 10. At this time, as illustrated in Fig. 9, a warp may occur in the sheet-shaped illumination panel 30 due to the residual stress or the like resulting from the manufacture.

According to illumination device 100 of the present embodiment, illumination panel 30 is fixed through the way of being sandwiched by main body 10 and installation cover 20. Even though a warp has occurred on illumination panel 30, when illumination device 100 is in the assembled state, illumination panel 30 will be pressed by pressing region 25 and mounting face 15 and thereby the warp will be corrected. Light emitting face 33 will be shaped (corrected) in correspondence with the shapes of mounting face 15 and pressing region 15 (transparent plate 22). As a result, it is possible to keep light emitting face 33 in the initially designed shape, making it possible to achieve desired light distribution characteristics.

### [Modifications of Embodiment 1]

### (First Modification)

Fig. 11 is a perspective view illustrating an installation cover 20A used in an illumination device according to a first modification of the above Embodiment 1. In installation cover 20A of the present modification, a plurality of through holes 22A may be disposed in an inner periphery of plate member 21. Different from installation cover 20 of the above Embodiment 1, installation cover 20A does not include transparent plate 22. Each through hole 22A is formed by perforating plate member 21, and through holes 22A are arranged in a lattice pattern, for example.

Pressing region 25 is defined by the remaining part without being perforated on the rear face of plate member 21. Thereby, pressing region 25 of the present modification is formed into the lattice pattern defined by the shape of each through hole 22A. For the purpose of correcting a warp on illumination panel 30, it is desirable that pressing region 25 is arranged uniformly relative to the entire part of light emitting face 33, like installation cover 20A having the lattice-patterned portion according to the present modification. On the other hand, pressing region 25 may not have to be arranged uniformly relative to the entire part of light emitting face 33; it is acceptable that pressing region 25 is formed somewhat non-uniformly as long as pressing region 25 can press a part of light emitting face 33 so as to correct the warp on illumination panel 30 to some extent, and it is also acceptable that pressing region 25 is formed into the other shapes from the viewpoint of design or the like. After installation cover 20A of the present modification is assembled into the illumination device, light emitting face 33 (see Fig. 1) of illumination panel 30 (see Fig. 1) is directly exposed out of through holes 22A.

When a part of light emitting face 33 is pressed by pressing region 25 against mounting face 15 through the lattice pattern, it is possible for light emitting face 33 to keep the initially designed shape. As a result, due to the contribution of installation cover 20A, it is possible for light emitting face 33 to achieve the initially designed light distribution characteristics without causing the problem that the intensity of light from light emitting face 33 may become irregular (uneven) depending on the direction of illumination.

### (Second Modification)

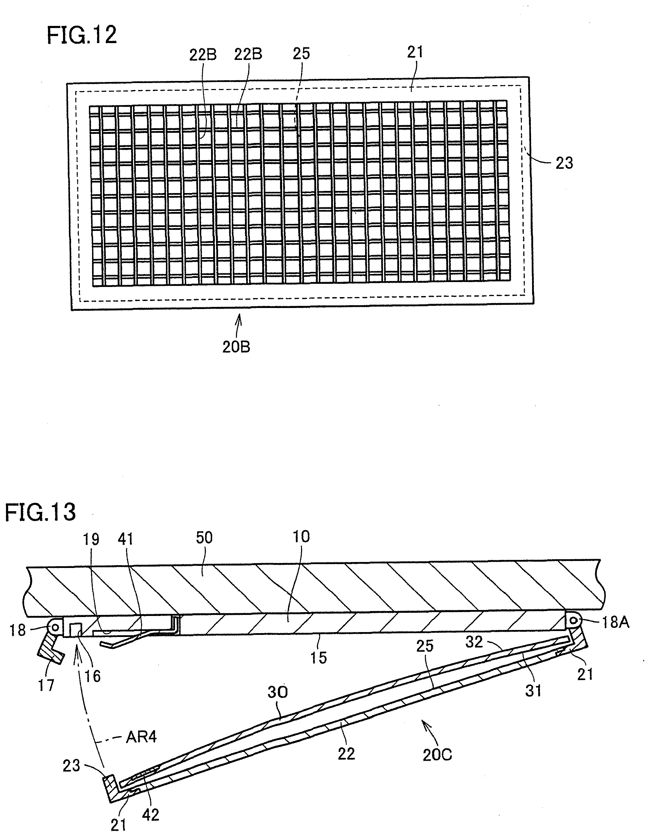

Fig. 12 is a plan view illustrating an installation cover 20B used in an illumination device according to a second modification of the above Embodiment 1. In installation cover 20B of the present modification, wires 22B are disposed in the inner periphery of plate member 21. Different from installation cover 20 of the above Embodiment 1, installation cover 20B does not include transparent plate 22. In place of transparent plate 22, wires 22B are disposed in a lattice pattern, for example, as illustrated in Fig. 12.

Pressing region 25 is defined by a rear face of wires 22B. Similarly to the disposition of through holes 22A in the first modification of the above Embodiment 1, pressing region 25 (wires 22B) may be formed into the other shapes from the viewpoint of design on a condition that it is possible for it to press a part of light emitting face 33.

After installation cover 20B of the present modification is assembled into the illumination device, light emitting face 33 (see Fig. 1) of illumination panel 30 (see Fig. 1) is exposed directly through the spaces between wires 22B. When a part of light emitting face 33 is pressed by pressing region 25 against mounting face 15 through the lattice pattern, it is possible for light emitting face 33 to keep the initially designed shape. As a result, due to the contribution of installation cover 20B, it is also possible for light emitting face 33 to achieve the initially designed light distribution characteristics without causing the problem that the intensity of light from light emitting face 33 may become irregular (uneven) depending on the direction of illumination.

### (Third Modification)

Fig. 13 is a cross sectional view illustrating an illumination device according to a third modification of the above Embodiment 1. An installation cover 20C used in the illumination device according to the present modification has a part thereof (herein, one end of installation cover 20C) preliminarily fixed at main body 10 through the intermediary of a supporting unit 18A. Installation cover 20C is rotatable about supporting unit 18A. Embedding portion 23 at the other end of installation cover 20C can be embedded into annular groove 16, as illustrated by an arrow AR4.

According to the illumination device of the present modification, preliminary (permanent) installation of installation cover 20C on main body 10 makes it possible to improve the working convenience of a worker in installing or replacing illumination panel 30.

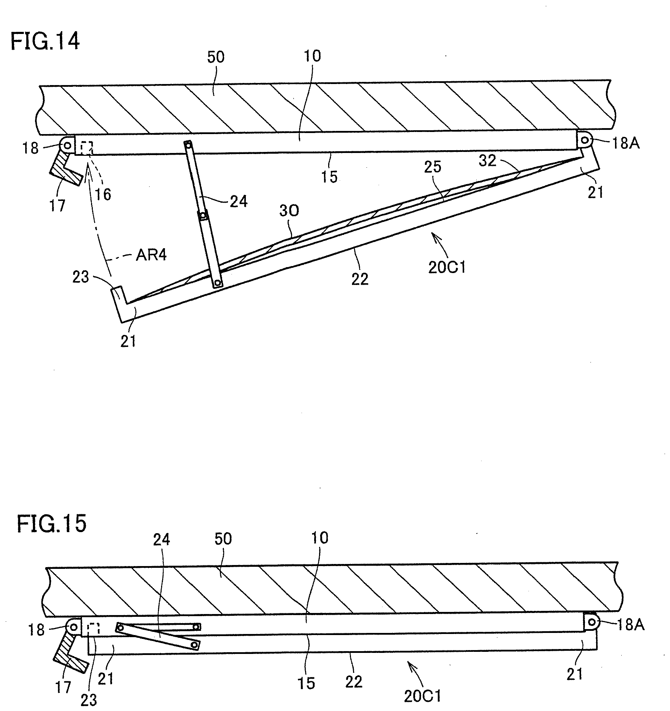

In an installation cover 20C1 as illustrated in Fig. 14, a restraint member 24 may be disposed between installation cover 20C1 and main body 10. Restraint member 24 is constructed by joining two thin plate members. Restraint member 24 may be a string-like member. As illustrated in Fig. 14, restraint member 24 may be disposed along the side surfaces of main body 10 and installation cover 20C1. Restraint member 24 is configured to restrain installation cover 20C1 from being opened too wide from main body 10 when installation cover 20C1 is rotated about supporting unit 18A. Due to the disposition of restraint member 24, the angle of installation cover 20C1 relative to main body 10 can be kept at a predetermined value, which makes it possible to easily mount illumination panel 30 onto installation cover 20C1.

As illustrated in Fig. 15, when installation cover 20C1 is installed on main body 10, restraint member 24 is folded along the side surfaces of main body 10 and installation cover 20C1. By disposing restraint member 24 at the side surfaces of main body 10 and installation cover 20C1, it is possible to prevent restraint member 24 from interrupting the installing work or replacing work of illumination panel 30, which further improves the working convenience.

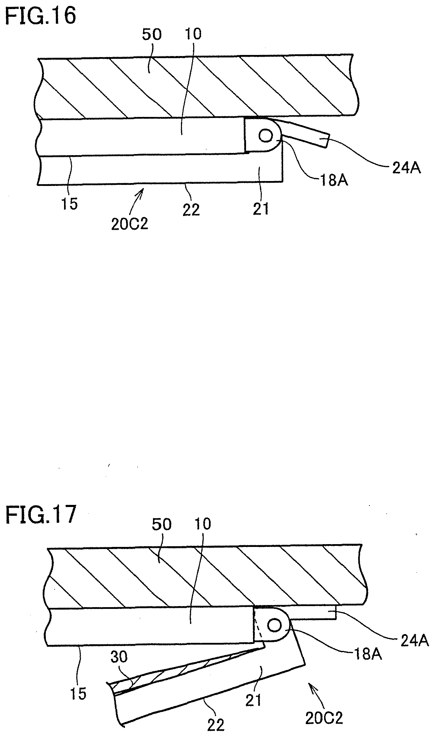

In an installation cover 20C2 as illustrated in Fig 16, a restraint member 24A may be disposed as a unit for restraining installation cover 20C2 from being opened too wide from main body 10. Restraint member 24A is disposed at the end of installation cover 20C2 where installation cover 20C2 is installed on supporting unit 18A. As illustrated in Fig 17, as installation cover 20C2 is rotated about supporting unit 18A, restraint member 24A contacts ceiling 50, which thereby restrains installation cover 20C2 from being opened too wide from main body 10. According to this configuration, it is also possible to obtain the same effects as the abovementioned restraint member 24 (see Figs. 14 and 15).

### (Fourth Modification)

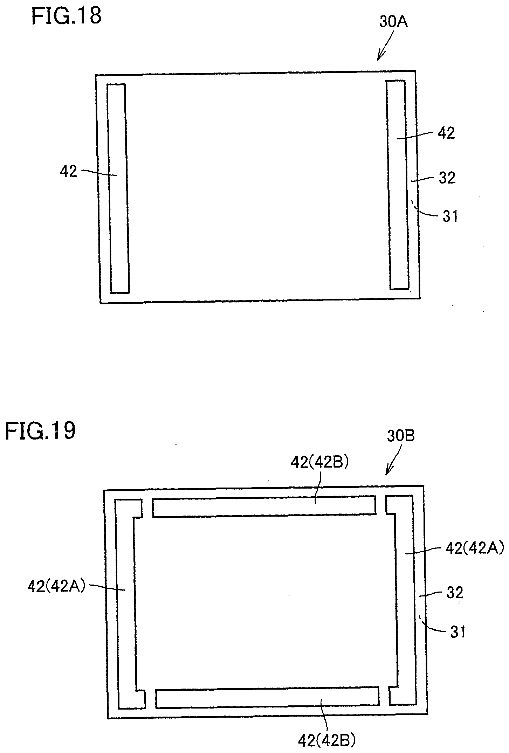

Fig. 18 is a bottom view of an illumination panel 30A used in an illumination device according to a fourth modification of the above Embodiment 1. Fig. 18 corresponds to Fig. 6 in the above Embodiment 1. In illumination panel 30A of the present modification, a pair of electrical contacts 42 are disposed on rear face 32 of illumination panel 30 by extending with a predetermined length along the peripheral edges thereof.

Meanwhile, electrical contacts 41 (not shown) disposed on main body 10 (not shown) are arranged at predetermined positions on mounting face 15 (not shown) in accordance with the positions of electrical contacts 42. Since electrical contacts 42 are sufficiently long relative to electrical contacts 41 on mounting face 15, even in the case where illumination panel 30A is fixed with a deviation to some extent, it is possible to obtain a good electrical connection between electrical contacts 41 and electrical contacts 42.

### (Fifth Modification)

Fig. 19 is a bottom view of an illumination panel 30B used in an illumination device according to a fifth modification of the above Embodiment 1. Fig. 19 corresponds to Fig. 6 in the above Embodiment 1. In illumination panel 30B of the present modification, a pair of positive electrical contacts 42 (42A) are disposed on rear face 32 of illumination panel 30B by extending with a predetermined length along the opposing peripheral edges thereof.

Similarly, a pair of negative electrical contacts 42 (42B) are disposed on rear face 32 of illumination panel 30B by extending with a predetermined length along the other opposing peripheral edges thereof. It is acceptable that illumination panel 30B has two positive electrical contacts 42 (42A) and two negative electrical contacts 42 (42B) disposed on rear face 32.

Similarly to the arrangement of electrical contacts 41 on mounting face 15 at predetermined positions in correspondence with the positions of electrical contacts 42 as in the fourth modification of the above Embodiment 1, in the fifth modification, electrical contacts 41 (not shown) disposed on main body 10 (not shown) are arranged at predetermined positions on mounting face 15 (not shown) in respective accordance with the positions of positive electrical contacts 42 (42A) and the position of negative electrical contacts 42 (42B). Since positive electrical contacts 42 (42A) and negative electrical contacts 42 (42B) are sufficiently long relative to electrical contacts 41 on mounting face 15, even in the case where illumination panel 30A is fixed with a deviation to some extent, it is possible to obtain a good electrical connection from electrical contacts 41 to electrical contacts 42 (42A) and to electrical contacts 42 (42B).

### (Sixth Modification)

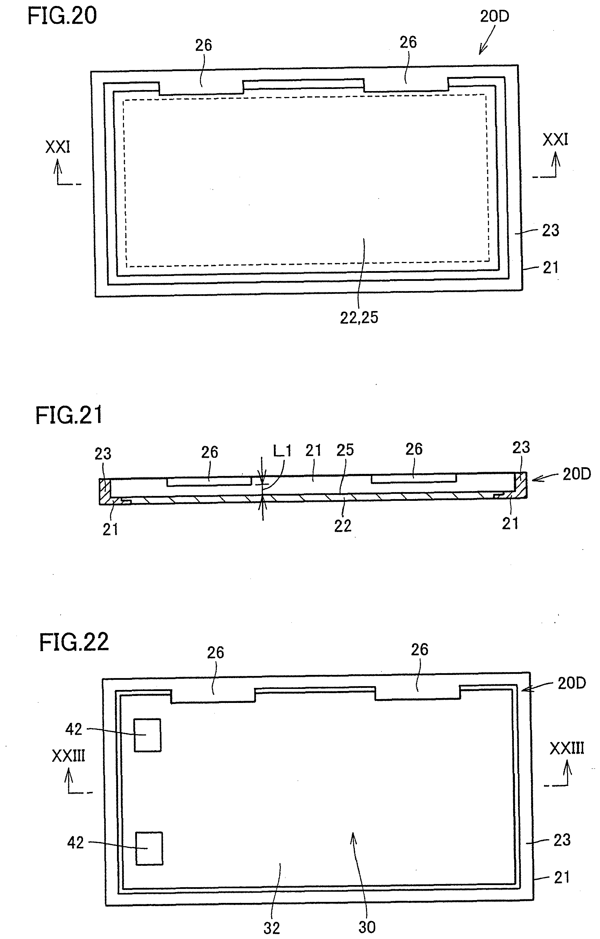

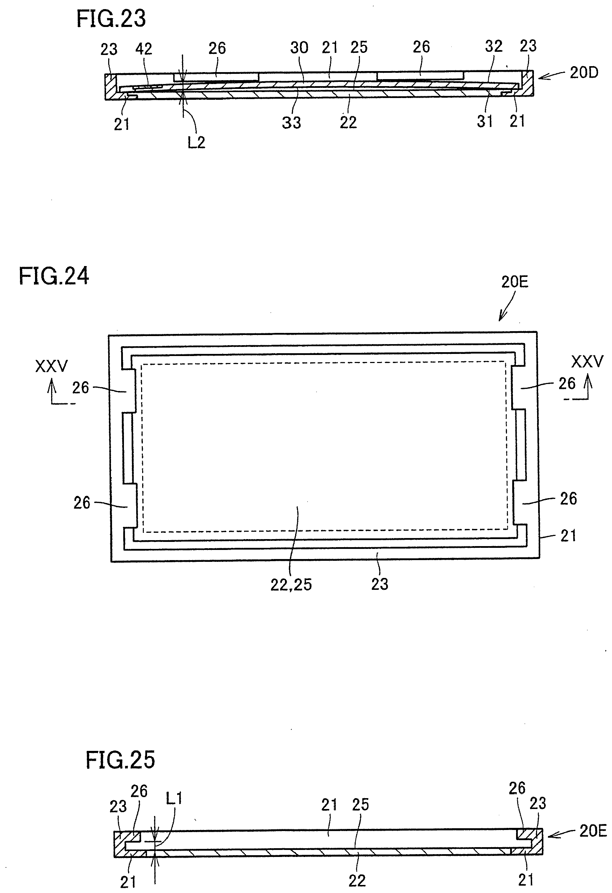

With reference to Figs. 20 to 23, an illumination device according to a sixth modification of the above Embodiment 1 will be described. Fig. 20 is a bottom view illustrating an installation cover 20D used in the illumination device according to the present modification. Fig. 21 is a cross sectional view taken along a line XXI-XXI in Fig. 20. Fig. 22 is a bottom view illustrating a state where illumination panel 30 is mounted on pressing region 25 of installation cover 20D. Fig. 23 is a cross sectional view taken along a line XXIII-XXIII in Fig. 22.

As illustrated in Figs. 20 and 21, prefixing portions 26 are disposed at a peripheral edge (herein, the top end of embedding portion 23 in the erecting direction) of installation cover 20D. Prefixing portions 26 of installation cover 20D are disposed side by side on one end of the annular-shaped embedding portion 23 in rectangular form, extending with a predetermined length so as to have a partial overlap with pressing region 25 in planar view. Each prefixing portion 26 is separated from pressing region 25 by a distance L1 (see Fig. 21). It should be noted that along with the disposition of prefixing portion 26, the shape of annular groove 16 (not shown) disposed in mounting face 15 (not shown) of main body 10 (not shown) may be changed in accordance with the shape of prefixing portion 26.

As illustrated in Figs. 22 and 23, in mounting illumination panel 30 on pressing region 25 of installation cover 20D, each end portion (having a thickness L2) of illumination panel 30 is inserted between prefixing portions 26 and pressing region 25 (thickness L2 < distance L1). Thereby, illumination panel 30 is prefixed relative to installation cover 20D. Due to the prefixing, illumination panel 30 is prevented from dropping (being disengaged) away from installation cover 20D, which makes it possible to improve the working convenience of a worker in installing or replacing illumination panel 30.

### (Seventh Modification)

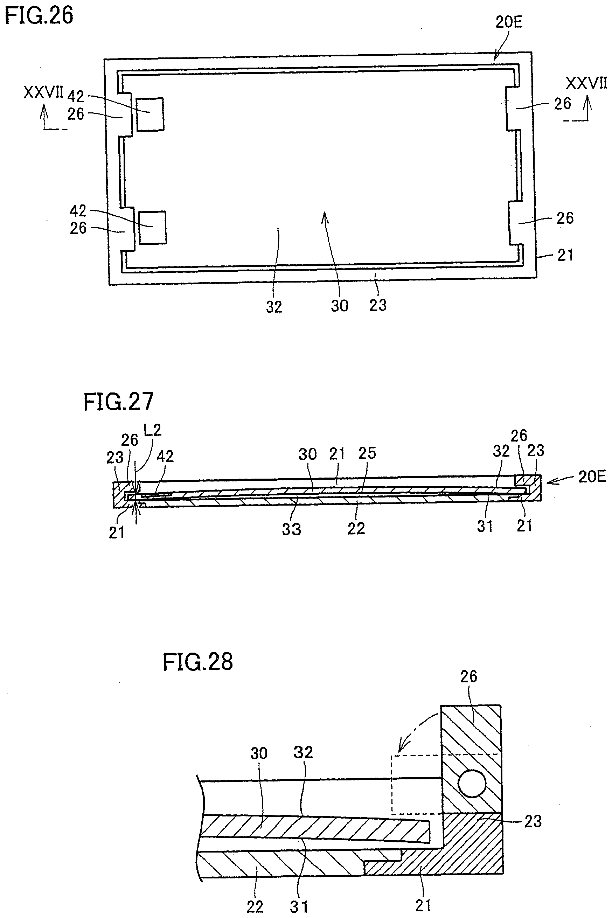

With reference to Figs. 24 to 27, an illumination device according to a seventh modification of the above Embodiment 1 will be described. Fig. 24 is a bottom view illustrating an installation cover 20E used in the illumination device according to the present modification. Fig. 25 is a cross sectional view taken along a line XXV-XXV in Fig. 24. Fig. 26 is a bottom view illustrating a state where illumination panel 30 is mounted on pressing region 25 of installation cover 20E. Fig. 27 is a cross sectional view taken along a line XXVII-XXVII in Fig. 26.

As illustrated in Figs. 24 and 25, prefixing portions 26 are disposed at peripheral edges (herein, the top ends of embedding portion 23 in the erecting direction) of installation cover 20E. Two prefixing portions 26 of installation cover 20E are disposed side by side on each of two opposing ends of the annular-shaped embedding portion 23 in rectangular form, extending with a predetermined length so as to have a partial overlap with pressing region 25 in planar view. Each prefixing portion 26 is separated from pressing region 25 by distance L1 (see Fig. 25). It should be noted that along with the disposition of prefixing portion 26, the shape of annular groove 16 (not shown) disposed on mounting face 15 (not shown) of main body 10 (not shown) may be changed in accordance with the shape of prefixing portion 26.

As illustrated in Figs. 26 and 27, in mounting illumination panel 30 on pressing region 25 of installation cover 20E, each end portion (having thickness L2) of illumination panel 30 is inserted between prefixing portions 26 and pressing region 25 (thickness L2 < distance L1). Similarly to installation cover 20D of the sixth modification (see Figs. 20 to 23) in the above, illumination panel 30 is prefixed relative to installation cover 20E. Due to the prefixing, illumination panel 30 is prevented from dropping (being disengaged) away from installation cover 20E, which makes it possible to improve the working convenience of a worker in installing or replacing illumination panel 30.

As illustrated in Fig. 28, prefixing portion 26 may be configured as being rotatable in the direction of an arrow in Fig. 28 about the top end of embedding portion 23 in the erecting direction toward illumination panel 30. In mounting illumination panel 30 on the installation cover (installation cover 20E), by erecting prefixing portions 26 (to the state illustrated in Fig. 28), it is possible to easily mount illumination panel 30 on the installation cover (installation cover 20E). After illumination panel 30 is mounted, illumination panel 30 is prefixed by rotating prefixing portion 26 toward illumination panel 30. Similarly, in the sixth modification (see Figs. 20 to 23) described in the above, prefixing portion 26 may be configured as being rotatable about the top end of embedding portion 23 in the erecting direction toward illumination panel 30.

### (Eighth Modification)

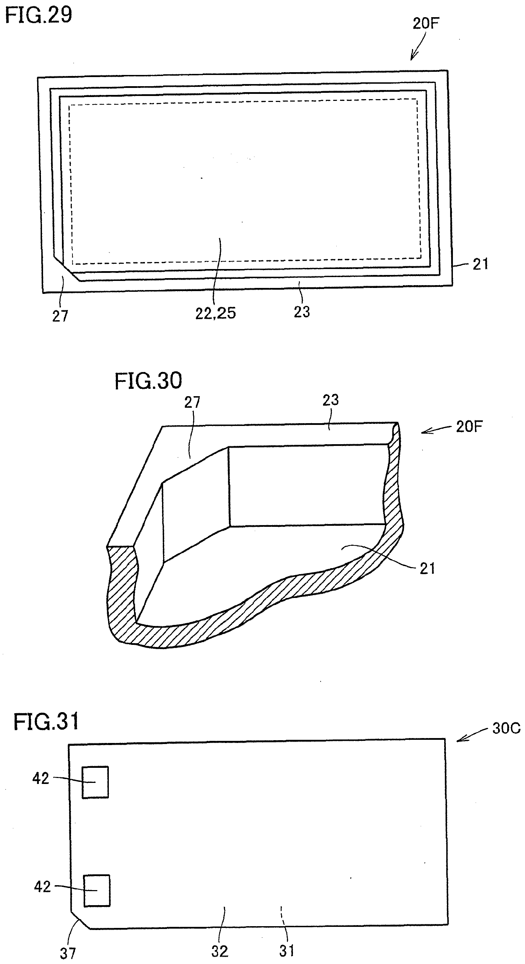

With reference to Figs. 29 to 31, an illumination device according to an eighth modification of the above Embodiment 1 will be described. Fig. 29 is a bottom view illustrating an installation cover 20F used in the illumination device according to the present modification. Fig. 30 is a perspective view illustrating a portion nearby a guide member 27 (the detail thereof will be described hereinafter) of installation cover 20F. Fig. 31 is a bottom view illustrating an illumination panel 30C used in the illumination device according to the present modification.

As illustrated in Figs. 29 and 30, guide member 27 (first guide portion) is formed at a peripheral edge (herein, a corner of the annular-shaped embedding portion 23 in rectangular form) of installation cover 20F. Guide member 27 is formed into a substantially triangular prism shape by extending from the top end of embedding portion 23 in the erecting direction to reach plate member 21 (in the direction orthogonal to the plane of paper in Fig. 29) and bulging from the corner of embedding portion 23 toward pressing region 25.

As illustrated in Fig. 31, a guide member 37 (first guide portion) is formed at a peripheral edge (herein, a corner of illumination panel 30C in rectangular form) of illumination panel 30C. Guide member 37 is formed by chamfering the corner. Guide member 37 fits with guide member 27 of installation cover 20F in shape and position.

In assembling the illumination device according to the present modification, illumination panel 30C is mounted on pressing region 25 of installation cover 20F in such a way that guide member 27 and guide member 37 fit each other (i.e., face each other). Illumination panel 30C cannot be mounted on pressing region 25 of installation cover 20F from another geometric angle (phase). Thereby, the so-called reverse insertion of illumination panel 30C into installation cover 20F is prevented, which in turn prevents electrical contacts 41 (not shown) on main body 10 (not shown) from being connected to electrical contacts 42 on illumination panel 30C in wrong polarity, making it possible to improve the working convenience of a worker in installing or replacing illumination panel 30C.

### (Ninth Modification)

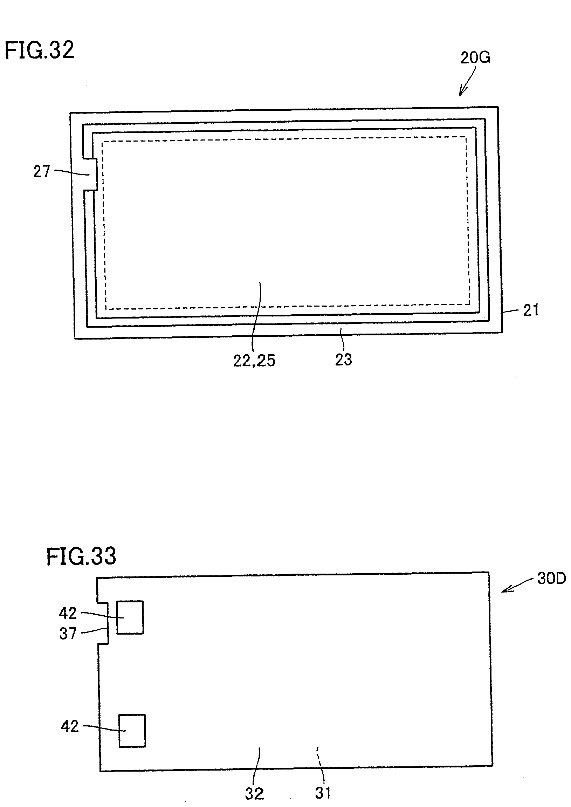

With reference to Figs. 32 and 33, an illumination device according to a ninth modification of the above Embodiment 1 will be described. Fig. 32 is a bottom view illustrating an installation cover 20G used in the illumination device according to the present modification. Fig. 33 is a bottom view illustrating an illumination panel 30D used in the illumination device according to the present modification.

As illustrated in Fig. 32, guide member 27 (second guide portion) is formed at a peripheral edge (herein, one end of the annular-shaped embedding portion 23 in rectangular form) of installation cover 20G. Guide member 27 is formed into a cuboid shape by extending from the top end of embedding portion 23 in the erecting direction to reach plate member 21 (in the direction orthogonal to the plane of paper in Fig. 32) and bulging from one end of embedding portion 23 toward pressing region 25.

As illustrated in Fig. 33, guide member 37 (first guide member) is formed at a peripheral edge (herein, one end of illumination panel 30D in rectangular form) of illumination panel 30D. Guide member 37 is formed by cutting out a part of the edge, fitting with guide member 27 of installation cover 20G in shape and position.

In assembling the illumination device according to the present modification, similarly to the eighth modification (see Figs. 29 to 31) in the above, illumination panel 30D is mounted on pressing region 25 of installation cover 20G in such a way that guide member 27 and guide member 37 fit each other (i.e., face each other). Illumination panel 30D cannot be mounted on pressing region 25 of installation cover 20G from another geometric angle (phase). Thereby, the so-called reverse insertion of illumination panel 30D into installation cover 20G is prevented, which in turn prevents electrical contacts 41 (not shown) on main body 10 (not shown) from being connected to electrical contacts 42 on illumination panel 30D in wrong polarity, making it possible to improve the working convenience of a worker in installing or replacing illumination panel 30D.

### (Tenth Modification)

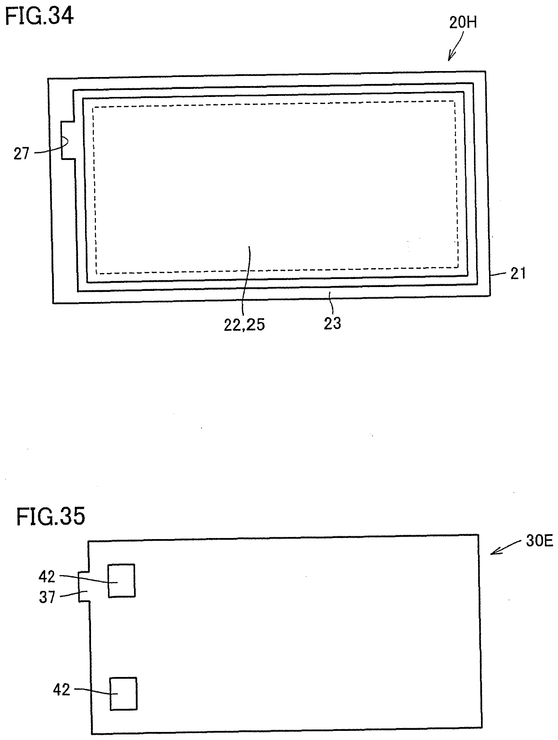

With reference to Figs. 34 and 35, an illumination device according to a tenth modification of the above Embodiment 1 will be described. Fig. 34 is a bottom view illustrating an installation cover 20H used in the illumination device according to the present modification. Fig. 35 is a bottom view illustrating an illumination panel 30E used in the illumination device according to the present modification.

As illustrated in Fig. 34, guide member 27 (first guide portion) is formed at a peripheral edge (herein, one end of the annular-shaped embedding portion 23 in rectangular form) of installation cover 20H. Guide member 27 is formed into a cuboid shape by extending from the top end of embedding portion 23 in the erecting direction to reach plate member 21 (in the direction orthogonal to the plane of paper in Fig. 34) and being cut away from one end of embedding portion 23 toward the opposite side of pressing region 25.

As illustrated in Fig. 35, guide member 37 (second guide portion) is formed at a peripheral edge (herein, one end of illumination panel 30E in rectangular form) of illumination panel 30E. Guide member 37 is formed by bulging from the end, fitting with guide member 27 of installation cover 20H in shape and position.

In assembling the illumination device according to the present modification, similarly to the eighth modification (see Figs. 29 to 31) and the ninth modification (see Figs. 32 and 33) in the above, illumination panel 30E is mounted on pressing region 25 of installation cover 20H in such a way that guide member 27 and guide member 37 fit each other (i.e., face each other). Illumination panel 30E cannot be mounted on pressing region 25 of installation cover 20H from another geometric angle (phase). Thereby, the so-called reverse insertion of illumination panel 30E into installation cover 20H is prevented, which in turn prevents electrical contacts 41 (not shown) on main body 10 (not shown) from being connected to electrical contacts 42 on illumination panel 30E in wrong polarity, making it possible to improve the working convenience of a worker in installing or replacing illumination panel 30E.

### [Embodiment 2]

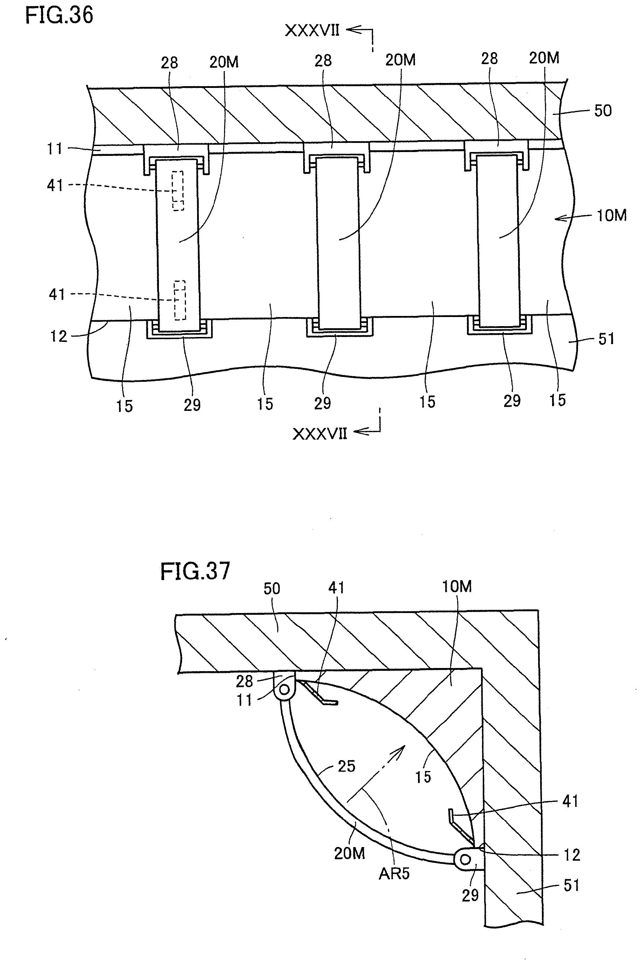

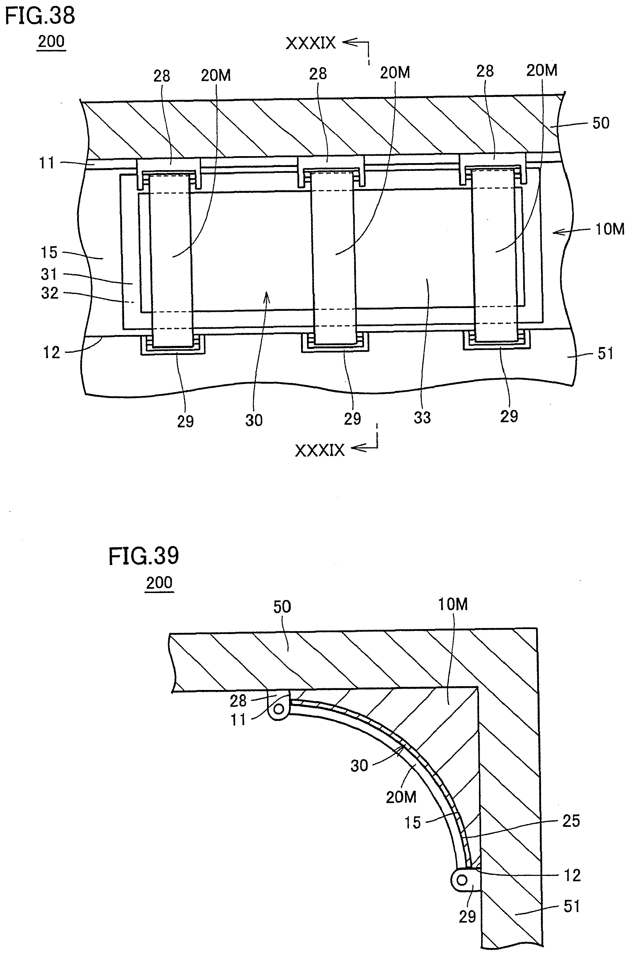

With reference to Figs. 36 to 39, an illumination device 200 (see Figs. 38 and 39) according to the present embodiment will be described. Fig. 36 is a front view illustrating a main body 10M and an installation cover 20M used in illumination device 200 according to the present embodiment. Fig. 37 is a cross sectional view taken along a line XXXVII-XXXVII in Fig. 36. Fig. 38 is a front view illustrating illumination device 200 in an assembled state (a state in which illumination panel 30 is installed between main body 10M and installation cover 20M). Fig. 39 is a cross sectional view taken along a line XXXIX-XXXIX in Fig. 38.

As illustrated in Figs. 36 and 37, main body 10M is formed into a substantially triangular prism shape having two ends 11 (first end) and 12 (second end) facing each other. Main body 10M can be fixed on ceiling 50 and a side wall 51 through the intermediary of its rear face. Main body 10M is made of, for example, aluminum or stainless steel.

Mounting face 15 of main body 10M is formed into an arc shape curving inward from end 11 toward end 12. A pair of electrical contacts 41 (first electrical contact) are disposed at predetermined positions on mounting face 15. Electrical contacts 41 are positioned in such a way that they can have a contact with electrical contacts (not shown) (corresponding to electrical contacts 42 in the above Embodiment 1) of illumination panel 30 when illumination panel 30 (see Figs. 38 and 39) is installed on main body 10M. As illustrated in Fig. 18 of the above Embodiment 1, the electrical contacts of illumination panel 30 may be disposed on the rear face of illumination panel 30 by extending with a predetermined length along the peripheral edges thereof. Since the electrical contacts of illumination panel 30 are sufficiently long relative to electrical contacts 41 on mounting face 15, even in the case where illumination panel 30 is fixed with a deviation to some extent, it is possible to obtain a good electrical connection between the electrical contacts of illumination panel 30 and electrical contacts 41.

Electrical contacts 41 may be fixed on mounting face 15 with a portion thereof protruding therefrom like a plate spring. Thus, when illumination panel 30 is installed on main body 10M, a good electrical connection is achieved between the electrical contacts of illumination panel 30 and electrical contacts 41 of main body 10M. Electrical contacts 41 penetrate through main body 10M and are connected to a predetermined power source (not shown). End 11 is disposed with a plurality of supporting units 28 side by side, and end 12 is disposed with a plurality of supporting units 29 side by side at positions facing supporting units 28, respectively.

Installation cover 20M is made of a transparent and elastically deformable material such as transparent acryl resin or polycarbonate having a rectangular shape, and is disposed across each facing pair of supporting units 28 and 29 like a bridge. Installation cover 20M is rotatably supported by supporting unit 28 and also by supporting unit 29. The thickness of installation cover 20M is, for example, 2 mm to 3 mm. The length of installation cover 20M in the longitudinal direction is longer than the direct distance between supporting unit 28 and supporting unit 29. The length of installation cover 20M in the longitudinal direction is roughly equal to the arc length of mounting face 15 in the same direction. A rear face of installation cover 20M defines pressing region 25 (see Fig. 37).

With reference to Figs. 38 and 39, illumination panel 30 is constructed in a similar manner to the above Embodiment 1. In assembling illumination device 200, while installation cover 20M and mounting face 15 are being separated from each other, illumination panel 30 is inserted between installation cover 20M and mounting face 15 from a transverse direction. Thereafter, installation cover 20M is elastically deformed along mounting face 15 between end 11 and end 12 in the direction of an arrow AR5 (see Fig. 37).

According to the elastic deformation, pressing region 25 of installation cover 20M presses light emitting face 33 of illumination panel 30 against mounting face 15 of main body 10M. According the abovementioned procedure, illumination device 200 illustrated in Figs. 38 and 39 is obtained. In illumination device 200, electrical power is supplied to light emitting face 33 of illumination panel 30 from an external power source (not shown) through the intermediary of electrical contacts 41 (see Fig. 36) disposed on main body 10M and the electrical contacts (not shown) disposed on illumination panel 30. When supplied with the electrical power, light emitting face 33 emits light, which makes illumination device 200 ready for illumination. In the present embodiment, a plurality of installation covers 20M disposed across each facing pair of supporting units 28 and 29 like a bridge are separated from each other by a predetermined distance, and are configured to retain light emitting face 33 by pressing the corresponding portions on light emitting face 33 against mounting face 15 of main body 10M; however, the width, the number, the disposing positions, the shape and the like of installation covers 20M relative to light emitting face 33 may be appropriately defined in such a range capable of pressing light emitting face 33 so as to maintain the shape thereof. On a condition of not affecting manipulation performance, installation cover 20M may be formed into one piece as illustrated in Fig. 1 of the above Embodiment 1 so as to press the entire part of light emitting face 33, or may be formed into a lattice pattern as illustrated in Fig. 11 of the first modification of the above Embodiment 1.

### (Functions and Effects)

The sheet-shaped illumination panel 30 may bend in the direction of gravity due to the weight (dead weight) of illumination panel 30 itself. According to illumination device 200 in the present embodiment, light emitting face 33 of illumination panel 30 is being pressed against mounting face 15 by pressing region 25 of installation cover 20M. Thus, light emitting face 33 is being sandwiched by pressing region 25 and mounting face 15, and thereby the shape thereof is maintained.

Due to the pressing by pressing region 25, light emitting face 33 will not bend, and thus, it is possible for it to maintain the initially designed shape. Thereby, it is possible for light emitting face 33 to achieve the initially designed light distribution characteristics without causing the problem that the intensity of light from light emitting face 33 may become irregular (uneven) depending on the direction of illumination.

In illumination device 200, illumination panel 30 is fixed through the way of being sandwiched by main body 10M and installation cover 20M. Even in the case where illumination panel 30 is manufactured in dimensions different from the initially designed dimensions in, for example, the longitudinal direction, since illumination panel 30 is being fixed against main body 10M and installation cover 20M according to the pressing from both the obverse face and the rear face, no crinkles will occur.

A warp may occur in illumination panel 30 due to the residual stress or the like resulting from the manufacture. Even in this situation, when illumination device 200 is in the assembled state, illumination panel 30 will be pressed by pressing region 25 and mounting face 15 to have the warp corrected. Light emitting face 33 is shaped (corrected) in correspondence with the shapes of mounting face 15 and pressing region 25. As a result, it is possible to keep light emitting face 33 in the initially designed shape, making it possible to achieve desired light distribution characteristics.

### [Modification of Embodiment 2]

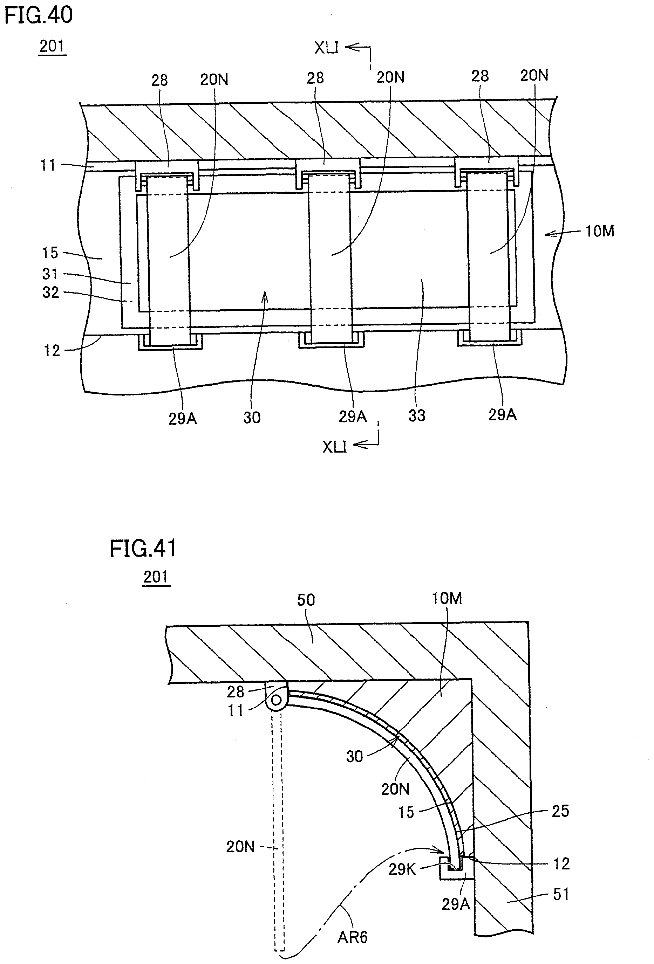

With reference to Figs. 40 and 41, an illumination device 201 according to a modification of the above Embodiment 2 will be described. Fig. 40 is a front view illustrating illumination device 201. Fig. 41 is a cross sectional view taken along a line XLI-XLI in Fig. 40.

In illumination device 201, only one end of an installation cover 20N is fixed at supporting unit 28 permanently, and a part of installation cover 20N (i.e., the other end of installation cover 20N) is detachable from supporting unit 29A. As illustrated by an arrow AR6 (see Fig. 41), the other end of installation cover 20N can be detachably embedded into a recess 29K disposed in supporting unit 29A.

In installing or replacing illumination panel 30, the other end of installation cover 20N is detached from supporting unit 29A. Since only one end of installation cover 20N is fixed at main body 10 (supporting unit 28), installation cover 20N hangs from supporting unit 28 (see dotted lines in Fig. 41). In this state, illumination panel 30 can be installed from the front side relative to mounting face 15.

Different from illumination device 200 in the above Embodiment 2, illumination panel 30 in the present modification may not be necessarily inserted from a traverse direction relative to mounting face 15. According to illumination device 201, it is possible to improve the working convenience of a worker in installing or replacing illumination panel 30.

Each embodiment has been described in the above on the basis of the present invention. The embodiments disclosed herein have been presented for the purpose of illustration and description but not limited in all aspects. It is intended that the scope of the present invention is defined by the scope of the claims and encompasses all modifications equivalent in meaning and scope to the claims.

### REFERENCE SIGNS LIST

10, 10M: main body; 11: end (first end); 12: end (second end); 13, 14: end; 15: mounting face; 16: annular groove; 17,17A: retaining member; 17C: coil spring; 17K: engaging section; 17T: tip end; 18, 18A, 28, 29, 29A: supporting unit; 19: cutout; 20, 20A, 20B, 20C, 20C1, 20C2, 20D, 20E, 20F, 20G, 20H, 20M, 20N: installation cover; 21: plate member; 22: transparent plate; 22A: through hole; 22B: wire; 23: embedding portion; 24, 24A: restraint member; 25: pressing region; 26: prefixing portion; 27: guide member (second guide member); 29K: recess; 30, 30A, 30B, 30C, 30D, 30E: illumination panel; 31: obverse face; 32: rear face; 33: light emitting face; 37: guide member (first guide member); 41: electrical contact (first electrical contact); 42: electrical contact (second electrical contact); 50: ceiling; 51: side wall; 100, 200, 201: illumination device; AR1, AR2, AR3, AR4, AR5, AR6: arrow; L1: distance; L2 thickness

## Claims

1. An illumination device, comprising:
a sheet-shaped, flexible illumination panel (30) including on its surface a light emitting face (33), said light emitting face being configured to emit light when supplied with electrical power;
a main body (10) including a mounting face (15) whereon said illumination panel (30) is to be mounted; and
an installation cover (20) being to be installed on said main body (10) and to sandwich the illumination panel with said main body,
said installation cover, in a state of being installed on said main body, including a pressing region (25) pressing said light emitting face (33) of said illumination panel (30), and
said pressing region of said installation cover being configured to press said light emitting face of said illumination panel, thereby causing said illumination panel to be pressed against said mounting face (15) of said main body (10), such that a shape of the light emitting face is defined and retained by a shape of the pressing region of the installation cover and a shape of the mounting face of the main body, **characterized in that** said light emitting face (33) of said illumination panel (30) is made of organic EL elements, and two supporting units (18) are disposed side by side at one end (11) of the main body (10) and another end (12) of the main body (10) facing each other, respectively, an L-shaped retaining member (17) is rotatably installed at at least two supporting units (18) at one end of the main body (10), a biasing unit is built inside the supporting unit (18), and
said biasing unit biases said retaining member (17) to rotate toward said mounting face (15), thereby causing said pressing region of said installation cover to press said light emitting face of said illumination panel.

2. The illumination device according to claim 1, wherein
said installation cover, in a state of being installed on said main body, includes a transparent region (22) covering said light emitting face of said illumination panel and an outer edge region (22) positioned at an outer edge of said transparent region,
said pressing region of said installation cover is included in said transparent region, and
said supporting unit (18) presses said outer edge region of said illumination panel against said main body, thereby causing said pressing region to press said light emitting face of said illumination panel.

3. The illumination device according to claim 1 or 2, wherein
said pressing region (25) presses an entire part of said light emitting face (33) against said mounting face (15).

4. The illumination device according to claim 1 or 2, wherein said pressing region (25) presses a part of said light emitting face (33) against said mounting face (15).

5. The illumination device according to claim 4, wherein said pressing region (25) is formed to have a lattice pattern.

6. The illumination device according to any one of claims 1 to 5, wherein
a first electrical contact (41) is disposed on said mounting face (15) of said main body (10), said first electrical contact being configured to receive electrical power supplied from a power source,
a second electrical contact (42) is disposed on a rear face (32) of said illumination panel (30), said second electrical contact being configured to supply electrical power received from said first electrical contact (41) to said light emitting face (33) of said illumination panel (30), and
said first electrical contact (41) and said second electrical contact (42) are arranged at positions to contact each other when said illumination panel (30) is installed on said main body (10).

7. The illumination device according to claim 6, wherein said second electrical contact (42) extends for a predetermined length along a peripheral edge of said rear face.

8. The illumination device according to any one of claims 1 to 4, wherein
a first guide portion (37) is disposed at a peripheral edge of said illumination panel (30),
a second guide portion (27) having a shape fitting with said first guide portion (37) is disposed at said installation cover (20), and
said illumination panel (30) is installed on said installation cover (20) with said first guide portion (37) being arranged to fit said second guide portion (27).

9. The illumination device according to any one of claims 1 to 8, wherein a prefixing portion (26) is disposed at a peripheral edge of said installation cover (20), said prefixing portion being configured to prefix said illumination panel (30) mounted on said pressing region (25).

10. The illumination device according to any one of claims 1 to 9, wherein
an annular groove (16) is disposed on a surface of said main body (10), said surface facing said illumination panel (30),
an embedding portion (23) is disposed on a surface of said installation cover (20), said surface facing said illumination panel (30), and
by embedding said embedding portion (23) into said annular groove (16),said installation cover (20) is fixed to said main body (10) and said pressing region (25) presses said illumination panel (30) against said mounting face (15).

11. The illumination device according to any one of claims 1 to 10, wherein a part of said installation cover (20) is fixed at said main body (10).

12. The illumination device according to claim 11, wherein
said installation cover (20) is rotatable about the part fixed at said main body (10), and
the illumination device further includes a restraint member (24, 24A) configured to restrain the rotation of said installation cover (20) so as to prevent an angle between said installation cover (20) and said main body (10) from going beyond a predetermined value.

13. The illumination device according to claim 1, wherein
said mounting face (15) of said main body (10) includes a first end (11) and a second end (12) disposed opposite to each other, and has a shape curving inward between said first end (11) and said second end (12), and
when said illumination panel (30) is in a state of being installed on said main body (10), said installation cover (20) deforms elastically along said mounting face (15) between said first end (11) and said second end (12), to cause said pressing region (25) of said installation cover (20) to press said light emitting face (33) of said illumination panel (30) so as to press said illumination panel against said mounting face (15).

14. The illumination device according to claim 13, wherein,
in removing said illumination panel from said main body, said installation cover deforms elastically in a direction away from said mounting face to release pressing of said light emitting face of said illumination by said pressing region of said installation cover panel.

15. The illumination device according to claim 14, wherein one end of said installation cover (20) is fixed at said main body (10), and the other end of said installation cover is detachable from said main body.

## Patentansprüche

1. Illuminationseinrichtung, umfassend:
ein blattförmiges, flexibles Illuminationspanel (30), einschließend auf seiner Oberfläche eine Licht emittierende Fläche (33), wobei die Licht emittierende Fläche eingerichtet ist, um Licht zu emittieren, wenn sie mit elektrischer Energie versorgt wird;
einen Hauptkörper (10), einschließend eine Montagefläche (15), auf der das Illuminationspanel (30) montiert werden soll; und
eine Installationsabdeckung (20), die auf dem Hauptkörper (10) installiert werden soll und um das Illuminationspanel mit dem Hauptkörper zu sandwichen,
wobei die Installationsabdeckung, in einem Zustand, in dem sie auf dem Hauptkörper installiert ist, eine Pressregion (25) einschließt, die die Licht emittierende Fläche (33) des Illuminationspanels (30) presst, und
wobei die Pressregion der Installationsabdeckung eingerichtet ist, um die Licht emittierende Fläche des Illuminationspanels zu pressen, wodurch das Illuminationspanel veranlasst wird, gegen die Montagefläche (15) des Hauptkörpers (10) gepresst zu werden, sodass eine Gestalt der Licht emittierenden Fläche definiert ist und beibehalten wird mittels einer Gestalt der Pressregion der Installationsabdeckung und einer Gestalt der Montagefläche des Hauptkörpers, **dadurch gekennzeichnet, dass**
die Licht emittierende Fläche (33) des Illuminationspanels (30) aus organischen EL Elementen hergestellt ist,
und zwei Stützeinheiten (18), angeordnet Seite an Seite an einem Ende (11) des Hauptkörpers (10) und einem anderen Ende (12) des Hauptkörpers (10), die einander entsprechend gegenüber liegen,
wobei ein L-förmiges Rückhalteelement (17) rotierbar an mindestens zwei Stützeinheiten (18) an einem Ende des Hauptkörpers (10) installiert ist, wobei eine Vorspanneinheit innerhalb der Stützeinheit (18) gebaut ist, und
wobei die Vorspanneinheit das Rückhalteelement (17) vorspannt, damit es in Richtung auf die Montagefläche (15) rotiert, wodurch die Pressregion der Installationsabdeckung veranlasst wird, die Licht emittierende Fläche des Illuminationspanels zu pressen.

2. Illuminationseinrichtung nach Anspruch 1, wobei
die Installationsabdeckung, in einem Zustand, in dem sie auf dem Hauptkörper installiert ist, eine transparente Region (22) einschließt, die die Licht emittierende Fläche des Illuminationspanels und eine äußere Kantenregion (22), positioniert an einer äußeren Kante der transparenten Region, abdeckt,
wobei die Pressregion der Installationsabdeckung in der transparenten Region eingeschlossen ist, und
wobei die Stützeinheit (18) die äußere Kantenregion des Illuminationspanels gegen den Hauptkörper presst, wodurch die Pressregion veranlasst wird, die Licht emittierende Fläche des Illuminationspanels zu pressen.

3. Illuminationseinrichtung nach Anspruch 1 oder 2, wobei
die Pressregion (25) einen ganzen Teil der Licht emittierenden Fläche (33) gegen die Montagefläche (15) presst.

4. Illuminationseinrichtung nach Anspruch 1 oder 2, wobei die Pressregion (25) einen Teil der Licht emittierenden Fläche (33) gegen die Montagefläche (15) presst.

5. Illuminationseinrichtung nach Anspruch 4, wobei die Pressregion (25) so geformt ist, dass sie ein Gittermuster aufweist.

6. Illuminationseinrichtung nach einem der Ansprüche 1 bis 5, wobei
ein erster elektrischer Kontakt (41) auf der Montagefläche (15) des Hauptkörpers (10) angeordnet ist, wobei der erste elektrische Kontakt eingerichtet ist, um elektrische Leistung, bereitgestellt von einer Leistungsquelle, zu empfangen,
ein zweiter elektrischer Kontakt (42) auf einer Rückseite (32) des Illuminationspanels (30) angeordnet ist, wobei der zweite elektrische Kontakt eingerichtet ist, um elektrische Leistung, empfangen von dem ersten elektrischen Kontakt (41), an die Licht emittierende Fläche (33) des Illuminationspanels (30) zu liefern, und
wobei der erste elektrische Kontakt (41) und der zweite elektrische Kontakt (42) an Positionen angeordnet sind, um einander zu kontaktieren, wenn das Illuminationspanel (30) auf dem Hauptkörper (10) installiert ist.

7. Illuminationseinrichtung nach Anspruch 6, wobei der zweite elektrische Kontakt (42) sich für eine vorbestimmte Länge entlang einer peripheren Kante der Rückseite erstreckt.

8. Illuminationseinrichtung nach einem der Ansprüche 1 bis 4, wobei
ein erstes Führungsteil (37) an einer peripheren Kante des Illuminationspanels (30) angeordnet ist,
ein zweites Führungsteil (27), das ein Gestaltfitting mit dem ersten Führungsteil (37) aufweist, an der Installationsabdeckung (20) angeordnet ist, und
das Illuminationspanel (30) auf der Installationsabdeckung (20) installiert ist, wobei das erste Führungsteil (37) geeignet ist, um das zweite Führungsteil (27) zu fitten.

9. Illuminationseinrichtung nach einem der Ansprüche 1 bis 8, wobei ein Vorbefestigungsteil (26) an einer peripheren Kante der Installationsabdeckung (20) angeordnet ist, wobei das Vorbefestigungsteil eingerichtet ist, um das Illuminationspanel (30) vorzubefestigen, das auf der Pressregion (25) montiert ist.

10. Illuminationseinrichtung nach einem der Ansprüche 1 bis 9, wobei
eine ringförmige Rille (16) auf einer Oberfläche des Hauptkörpers (10) angeordnet ist, wobei die Oberfläche dem Illuminationspanel (30) gegenüber liegt,
ein Einbettungsteil (23) auf einer Oberfläche der Installationsabdeckung (20) angeordnet ist, wobei die Oberfläche dem Illuminationspanel (30) gegenüber liegt, und
mittels Einbettens des Einbettungsteils (23) in die ringförmige Rille (16) die Installationsabdeckung (20) an dem Hauptkörper (10) befestigt ist und wobei die Pressregion (25) das Illuminationspanel (30) gegen die Montagefläche (15) presst.

11. Illuminationseinrichtung nach einem der Ansprüche 1 bis 10, wobei ein Teil der Installationsabdeckung (20) an dem Hauptkörper (10) befestigt ist.

12. Illuminationseinrichtung nach Anspruch 11, wobei
die Illuminationsabdeckung (20) rotierbar um den an dem Hauptkörper (10) befestigten Teil ist, und
wobei die Illuminationseinrichtung weiter ein Einschränkungselement (24, 24A) einschließt, eingerichtet, um die Rotation der Installationsabdeckung (20) so einzuschränken, um einen Winkel zwischen der Installationsabdeckung (20) und dem Hauptkörper (10) daran zu hindern, über einen vorbestimmten Wert hinaus zu gehen.

13. Illuminationseinrichtung nach Anspruch 1, wobei
die Montagefläche (15) des Hauptkörpers (10) ein erstes Ende (11) und ein zweites Ende (12), einander gegenüberliegend angeordnet, einschließt und eine Gestaltkrümmung nach Innen zwischen dem ersten Ende (11) und dem zweiten Ende (12) aufweist, und
wenn das Illuminationspanel (30) in einem Zustand ist, in dem es an dem Hauptkörper (10) installiert wird, deformiert sich die Installationsabdeckung (20) elastisch entlang der Montagefläche (15) zwischen dem ersten Ende (11) und dem zweiten Ende (12), um die Pressregion (25) der Installationsabdeckung (20) zu veranlassen, die Licht emittierende Fläche (33) des Illuminationspanels (30) zu pressen, sodass das Illuminationspanel gegen die Montagefläche (15) gepresst wird.

14. Illuminationseinrichtung nach Anspruch 13, wobei
beim Entfernen des Illuminationspanels von dem Hauptkörper, sich die Installationsabdeckung elastisch in eine Richtung weg von der Montagefläche deformiert, um das Pressen der Licht emittierenden Fläche der Illumination mittels der Pressregion des Installationsabdeckungspanels zu lösen.

15. Illuminationseinrichtung nach Anspruch 14, wobei ein Ende der Installationsabdeckung (20) an dem Hauptkörper (10) befestigt ist, und das andere Ende der Installationsabdeckung von dem Hauptkörper abnehmbar ist.

## Revendications

1. Dispositif d'éclairage, comprenant :
un panneau d'éclairage flexible en forme de plaque (30) incluant sur sa surface une face luminescente (33), ladite face luminescente étant configurée pour émettre de la lumière lorsqu'elle est approvisionnée en puissance électrique ;
un corps principal (10) incluant une face de montage (15) sur laquelle ledit panneau d'éclairage (30) doit être monté ; et
un couvercle d'installation (20) devant être installé sur ledit corps principal (10) et prendre en sandwich le panneau d'éclairage avec ledit corps principal,
ledit couvercle d'installation, dans un état où il est installé sur ledit corps principal, incluant une région de pression (25) comprimant ladite face luminescente (33) dudit panneau d'éclairage (30), et
ladite région de pression dudit couvercle d'installation étant configurée pour presser ladite face luminescente dudit panneau d'éclairage, en amenant ainsi ledit panneau d'éclairage à être comprimé contre ladite face de montage (15) dudit corps principal (10), de sorte qu'une forme de la face luminescente soit définie et retenue par une forme de la région de pression du couvercle d'installation et une forme de la face de montage du corps principal, **caractérisé en ce que**
ladite face luminescente (33) dudit panneau d'éclairage (30) est constituée d'éléments électroluminescents organiques,
et deux unités de support (18) sont disposées côte à côte à une extrémité (11) du corps principal (10) et à une autre extrémité (12) du corps principal (10) face à face, respectivement,
un élément de retenue en forme de L (12) est installé de manière rotative au niveau d'au moins deux unités de support (18) à une extrémité du corps principal (10), une unité de sollicitation est établie à l'intérieur de l'unité de support (18), et
ladite unité de sollicitation sollicite ledit élément de retenue (17) pour qu'il tourne vers ladite face de montage (15), en amenant ainsi ladite région de pression dudit couvercle d'installation à comprimer ladite face luminescente dudit panneau d'éclairage.

2. Dispositif d'éclairage selon la revendication 1, dans lequel
ledit couvercle d'installation, dans un état où il est installé sur ledit corps principal, inclut une zone transparente (22) recouvrant ladite face luminescente dudit panneau d'éclairage et une zone de bord externe (22) positionnée au niveau d'un bord externe de ladite zone transparente,
ladite région de pression dudit couvercle d'installation est incluse dans ladite zone transparente, et
ladite unité de support (18) comprime ladite zone de bord externe dudit panneau d'éclairage contre ledit corps principal, en amenant ainsi ladite région de pression à comprimer ladite face luminescente dudit panneau d'éclairage.

3. Dispositif d'éclairage selon la revendication 1 ou 2, dans lequel
ladite région de pression (25) comprime une partie entière de ladite face luminescente (33) contre ladite face de montage (15).

4. Dispositif d'éclairage selon la revendication 1 ou 2, dans lequel ladite région de pression (25) comprime une partie de ladite face luminescente (33) contre ladite face de montage (15).

5. Dispositif d'éclairage selon la revendication 4, dans lequel ladite région de pression (25) est formée pour avoir un motif de grille.

6. Dispositif d'éclairage selon l'une quelconque des revendications 1 à 5, dans lequel
un premier contact électrique (41) est disposé sur ladite face de montage (15) dudit corps principal (10), ledit premier contact électrique étant configuré pour recevoir une puissance électrique approvisionnée depuis une source de puissance,
un second contact électrique (42) est disposé sur une face arrière (32) dudit panneau d'éclairage (30), ledit second contact électrique étant configuré pour approvisionner en puissance électrique reçue du premier contact électrique (41) vers ladite face luminescente (33) dudit panneau d'éclairage (30), et
ledit premier contact électrique (41) et ledit second contact électrique (42) sont agencés dans des positions pour entrer en contact l'un avec l'autre lorsque ledit panneau d'éclairage (30) est installé sur ledit corps principal (10).

7. Dispositif d'éclairage selon la revendication 6, dans lequel ledit second contact électrique (42) s'étend sur une longueur prédéterminée le long d'un bord périphérique de ladite face arrière.

8. Dispositif d'éclairage selon l'une quelconque des revendications 1 à 4, dans lequel
une première partie de guidage (37) est disposée au niveau d'un bord périphérique dudit panneau d'éclairage (30),
une seconde partie de guidage (27) ayant une forme s'adaptant à ladite première partie de guidage (37) est disposée au niveau dudit couvercle d'installation (20), et
ledit panneau d'éclairage (30) est installé sur ledit couvercle d'installation (20) avec ladite première partie de guidage (37) agencée pour s'adapter à ladite seconde partie de guidage (27).

9. Dispositif d'éclairage selon l'une quelconque des revendications 1 à 8, dans lequel une partie de préfixation (26) est disposée au niveau d'un bord périphérique dudit couvercle d'installation (20), ladite partie de préfixation étant configurée pour préfixer ledit panneau d'éclairage (30) monté sur ladite région de pression (25).

10. Dispositif d'éclairage selon l'une quelconque des revendications 1 à 9, dans lequel
une rainure annulaire (16) est disposée sur une surface dudit corps principal (10), ladite surface faisant face audit panneau d'éclairage (30),
une partie d'enrobage (23) est disposée sur une surface dudit couvercle d'installation (20), ladite surface faisant face audit panneau d'éclairage (30), et
en incorporant ladite partie d'incorporation (23) dans ladite rainure annulaire (16), ledit couvercle d'installation (20) est fixé audit corps principal (10) et ladite région de pression (25) comprime ledit panneau d'éclairage (30) contre ladite face de montage (15).

11. Dispositif d'éclairage selon l'une quelconque des revendications 1 à 10, dans lequel une partie dudit couvercle d'installation (20) est fixée au niveau dudit corps principal (10).

12. Dispositif d'éclairage selon la revendication 11, dans lequel
ledit couvercle d'installation (20) peut tourner autour de la partie fixée au niveau dudit corps principal (10), et
le dispositif d'éclairage inclut en outre un élément de restriction (24, 24A) configuré pour restreindre la rotation dudit couvercle d'installation (20) de façon à empêcher un angle entre ledit couvercle d'installation (20) et ledit corps principal (10) d'aller au-delà d'une valeur prédéterminée.

13. Dispositif d'éclairage selon la revendication 1, dans lequel
ladite face de montage (15) dudit corps principal (10) comprend une première extrémité (11) et une seconde extrémité (12) disposées à l'opposé l'une de l'autre, et a une forme s'incurvant vers l'intérieur entre ladite première extrémité (11) et ladite seconde extrémité (12), et
lorsque ledit panneau d'éclairage (30) est dans un état où il est installé sur ledit corps principal (10), ledit couvercle d'installation (20) se déforme élastiquement le long de ladite face de montage (15) entre ladite première extrémité (11) et ladite seconde extrémité (12), pour amener ladite région de pression (25) dudit couvercle d'installation (20) à comprimer ladite face luminescente (33) dudit panneau d'éclairage (30) de façon à comprimer ledit panneau d'éclairage contre ladite face de montage (15).

14. Dispositif d'éclairage selon la revendication 13, dans lequel
en enlevant ledit panneau d'éclairage dudit corps principal, ledit couvercle d'installation se déforme élastiquement dans une direction opposée à ladite face de montage pour relâcher la compression de ladite face luminescente dudit éclairage par ladite région de pression dudit panneau de couvercle d'installation.

15. Dispositif d'éclairage selon la revendication 14, dans lequel une extrémité dudit couvercle d'installation (20) est fixée au niveau dudit corps principal (10), et l'autre extrémité dudit couvercle d'installation est détachable dudit corps principal.
